(19) Europäisches Patentamt
European Patent Office
Office européen des brevets

(11) EP 3 188 314 B1

(12) EUROPEAN PATENT SPECIFICATION

(45) Date of publication and mention of the grant of the patent:
**07.07.2021 Bulletin 2021/27**

(21) Application number: **15835308.6**

(22) Date of filing: **18.08.2015**

(51) Int Cl.:
***H01B 1/02*** *(2006.01)* ***H01B 1/22*** *(2006.01)*
***H05K 3/32*** *(2006.01)*

(86) International application number:
**PCT/JP2015/073092**

(87) International publication number:
**WO 2016/031619 (03.03.2016 Gazette 2016/09)**

(54) **CONDUCTOR CONNECTION STRUCTURE, METHOD FOR PRODUCING SAME, CONDUCTIVE COMPOSITION, AND ELECTRONIC COMPONENT MODULE**

LEITERVERBINDUNGSSTRUKTUR, VERFAHREN ZUR HERSTELLUNG DAVON, LEITERZUSAMMENSETZUNG UND ELEKTRONISCHES KOMPONENTENMODUL

STRUCTURE DE CONNEXION DE CONDUCTEUR, PROCÉDÉ DE FABRICATION DE CELLE-CI, COMPOSITION CONDUCTRICE ET MODULE DE COMPOSANT ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.08.2014 JP 2014176169**

(43) Date of publication of application:
**05.07.2017 Bulletin 2017/27**

(73) Proprietor: **Mitsui Mining & Smelting Co., Ltd.**
**Shinagawa-ku**
**Tokyo 141-8584 (JP)**

(72) Inventors:
- **KAMIKORIYAMA, Yoichi**
  **Ageo-shi**
  **Saitama 362-0021 (JP)**
- **YAMAUCHI, Shinichi**
  **Ageo-shi**
  **Saitama 362-0021 (JP)**
- **YOSHIDA, Mami**
  **Ageo-shi**
  **Saitama 362-0021 (JP)**
- **NAKAYAMA, Shigeki**
  **Ageo-shi**
  **Saitama 362-0021 (JP)**

(74) Representative: **Forstmeyer, Dietmar et al**
**BOETERS & LIECK**
**Oberanger 32**
**80331 München (DE)**

(56) References cited:
**EP-A1- 1 847 575**
**WO-A1-2006/070747**
**WO-A1-2012/081255**
**JP-A- H08 311 347**
**JP-A- 2010 065 277**
**US-A- 6 086 790**
**US-A1- 2005 182 161**

- **DATABASE WPI Week 199906 28 February 1999 (1999-02-28) Thomson Scientific, London, GB; AN 1999-066693 XP002778956, -& JP H10 312712 A (ASAHI KASEI KOGYO KK) 24 November 1998 (1998-11-24)**
- **DATABASE WPI Week 201023 25 March 2010 (2010-03-25) Thomson Scientific, London, GB; AN 2010-D22258 XP002778957, -& JP 2010 065277 A (NIPPON HANDA KK) 25 March 2010 (2010-03-25)**
- **None**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 188 314 B1

## Description

### Technical Field

This invention relates to a conductor connection structure and a method for making the same. The invention also relates to a conductive composition and an electronic component module.

### Background Art

Electrical connection between a wiring board and an electronic device mounted thereon is generally accomplished by soldering. Solder is essentially a lead-containing alloy. Because lead is identified as a substance of environmental concern, the increasing awareness of environmental issues has boosted development of various lead-free solder compositions.

In recent years, the use of semiconductor devices called power devices as power conversion and control equipment, such as inverters, has been increasing. Because power devices are for controlling a high current unlike integrated circuits, such as memories and microprocessors, they generate a very large amount of heat in operation. Accordingly, heat resistance is required of the solder used to mount a power device. However, the lead-free solder has a disadvantage of lower heat resistance than general lead-containing solder.

Various techniques replacing the use of solder have been proposed, in which metallic particles are applied to an object through various coating means to form a conductive film. For example, Patent Literature 1 below discloses a method including applying a liquid composition containing copper oxide particles to a substrate and heating the applied composition while supplying formic acid gas to form a metallic copper film. What is aimed in Patent Literature 1 is to produce an essentially void-free dense metallic copper film.

Patent Literature 2 describes a conductor connection structure comprising a connection being made mainly of copper, having a plurality of voids, and containing an organic resin in the voids.

Patent Literature 3 describes an electro-conductive composition, suitable for use in an electrical connection, comprising copper particles with larger and smaller particle sizes and an amine compound.

### Citation List

#### Patent Literature

Patent Literature 1: JP 2011-238737A
Patent Literature 2: JP 2010 065277 A
Patent Literature 3: JP H10 312712 A

### Summary of Invention

However, a metallic copper film, when exposed to high temperatures for a long time, tends to reduce in mechanical strength or heat resistance reliability due to oxidation. Oxidation of copper can also cause an increase of electrical resistance.

An object of the invention is to provide a structure for connecting conductors that can eliminate various problems associated with the relevant conventional techniques aforementioned, a method for making such a connection structure, and a conductive composition suitable to make the connection structure.

The present invention provides a connection structure as defined in claim 1 comprising two conductors and a copper connection electrically connecting the conductors,
the connection being made mainly of copper, having a plurality of voids, and containing an organosilicon compound in the voids, wherein the organosilicon compound has a moeity represented by formula (2) as defined below.

The present invention also provides, as an electroconductive composition that can be suitably used for making the connection structure above-mentioned,
an electroconductive composition as defined in claim 4 comprising large-diameter copper particles having a relatively large diameter and small-diameter copper particles having a smaller diameter than the large-diameter copper particles, an amine compound, and a silane coupling agent having a reactive group reactive with the amine compound.

The present invention further provides, as a suitable method for making the connection structure above-mentioned,
a method for making a conductor connection structure, comprising:

allowing the electro conductive composition above-mentioned to intervene between two conductors, and
heat-treating the electroconductive composition between the conductors to form a conductive connection, thereby achieving electrical connection between the conductors.

The present invention further provides an electronic component module as defined in claim 6 comprising a wiring board having a conductive land, an electronic component mounted on the conductive land and having a terminal, and a copper connection electrically connecting the conductive land and the terminal,
the connection being made mainly of copper, having a plurality of voids, and containing an organosilicon compound in the voids.

Brief Description of Drawings

[Fig.1] Fig. 1 schematically illustrates an embodiment of the conductor connection structure of the invention.
[Fig. 2] Fig. 2(a), Fig. 2(b), and Fig. 2(c) schematically illustrate the steps for making the connection structure shown in Fig. 1 in the sequential order.
[Fig. 3] Fig. 3(a) and Fig. 3(b) are scanning electron micrographs of the connection of the connection structure obtained in Example 1.
[Fig. 4] Fig. 4 is an EDX elemental mapping image of the connection of the connection structure obtained in Example 1.

Description of Embodiments

The invention will be described generally with reference to its preferred embodiment by way of the accompanying drawings. Fig. 1 is a schematic illustration of an embodiment of the conductor connection structure of the invention. The connection structure 10 of Fig. 1 has a wiring board 20 and an electronic component 30 electrically connected to each other. The wiring board 20 has on its one side 20a conductive lands 21 made of a conductor. The electronic component 30 has on its lower side 30a terminals 31 made of a conductor, such as electrode pads. The conductive land 21 of the wiring board 20 and the terminal 31 of the electronic component 30 are electrically interconnected via a copper connection 11. The term "copper connection" refers to a connection made of a conductive material mainly comprising copper. The conductive material forming the connection 11 may consist solely of copper or contain copper as a main component, for example, in a proportion of more than 50% by mass and any other conductive materials. The electronic component 30 is mounted on the conductive lands 21 of the wiring board 20 via the connections 11 to form an electronic component module.

A variety of electronic components are applicable as the component 30, including active devices such as semiconductors of various types and passive devices such as resistors, capacitors, and coils. The wiring board 20 has a conductive land 21 on at least one side thereof and may be either single-sided or double-sided. The wiring board 20 may have a single-layer or multi-layer structure.

One of the characteristics of the connection structure 10 of the embodiment resides in the microstructure of the connection 11. Specifically, the connection 11 has voids at least in the inside thereof. The voids may be continuous or discontinuous. What form the voids may have is not critical in the invention.

As will be verified in Examples given later (see Fig. 3(b)), the connection 11 preferably has a microstructure composed of an aggregate of a plurality of particles that are fused and bonded to each other to form a neck therebetween. The term "neck" refers to a narrow portion formed between adjacent particles fused and bonded to each other by the action of heat, the portion being narrower than other potions.

As will be verified in Examples given later (see Fig. 3(a)), it is particularly preferred that the connection 11 have a microstructure composed of a plurality of large-diameter copper particles that are relatively large in diameter and small-diameter copper particles that are smaller in diameter than the large-diameter copper particles, the large-diameter copper particles each being fused and bonded to small-diameter copper particles, the small-diameter copper particles being fused and bonded to each other, and a plurality of small-diameter copper particles being located around every large-diameter copper particle. It is preferred that the voids include a first void and a second void, the first void being formed between the large-diameter copper particle and the small-diameter copper particle which are fused and bonded to each other and the second void being formed between the small-diameter copper particles which are fusion-bonded to one another. The large-diameter copper particles may be fused and bonded to each other, in which case, the void may be formed therebetween.

Both the large-diameter and small-diameter copper particles are made mainly of copper. They may be made solely of copper or may contain copper as a main component (e.g., in a proportion of more than 50% by mass) and a material other than copper. It is preferred from the viewpoint of conductivity that the large-diameter copper particles

contain at least 90 mass% of copper. The composition of the large-diameter copper particles and that of the small-diameter copper particles may be the same or different.

In the connection 11 having a microstructure including a plurality of voids, the voids are spaces that are each defined by the material containing copper as a main component. An organosilicon compound is present in the voids. Preferably, the organosilicon compound is present on the surfaces defining the voids, i.e., the surfaces of the material facing the voids. The presence of the organosilicon compound on those surfaces alleviates the stress caused by dimensional changes of the connection 11 of the connection structure 10 even when thermal burden is imposed on the connection 11, i.e., even when dimensional changes is caused by expansion/contraction induced by thermal burden, thereby to effectively prevent reduction of mechanical strength of the connection 11. Furthermore, when the organosilicon compound is present on the surfaces defining the voids, the area ratio of copper, the main component making up the connection 11, exposed on those surfaces decreases to accordingly lower the susceptibility of the copper to oxidation, namely, to increase oxidation resistance of the copper. To increase oxidation resistance serves to keep the electrical resistance of the connection 11 low. The amine compound and the silane coupling agent included in the conductive material 12 prevent excessive sintering of copper particles during firing, i.e., prevent considerable shrinkage of the conductive material 12 to provide a void-containing connection 11 with a desired dimension. The resulting connection structure 10 thus exhibits high mechanical bonding strength. As discussed, the connection structure 10 of the embodiment has high heat resistance, high bonding strength, and low resistance. The connection structure 10 of the embodiment is superior to solder in that the connection 11 does not remelt on heat application unlike solder.

As a result of study, the inventors have ascertained that it is preferred for the organosilicon compound to be a nitrogen-containing compound to enhance the above discussed advantageous effects. The organosilicon compound according to the invention has a moiety represented by formula (2):

[Chem. 1]

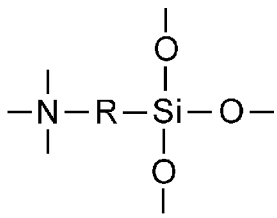

(1)

wherein R represents a divalent hydrocarbon linking group;

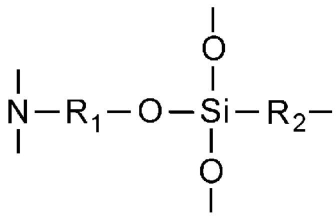

(2)

wherein $R_1$ and $R_2$ each represent a divalent hydrocarbon linking group; and

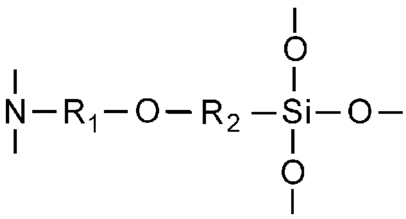

(3)

wherein $R_1$ and $R_2$ each represent a divalent hydrocarbon linking group.

The divalent hydrocarbon linking groups represented by R, $R_1$, and $R_2$ in formulae (1) to (3) each can independently be a straight or branched chain group having 1 to 10, preferably 1 to 6, carbon atoms. In the hydrocarbon linking groups, one or more hydrogen atoms thereof may be replaced with a functional group, such as a hydroxyl group, an aldehyde group, or a carboxyl group. The hydrocarbon linking group may have its hydrocarbon main chain interrupted by a divalent linkage, such as -O- or -S-.

The presence/absence of the organosilicon compound in the voids of the connection 11 can be confirmed by elemental mapping of silicon, carbon, and/or nitrogen using, e.g., EDX on a cross-section of the connection 11 to determine whether silicon, carbon, and/or nitrogen is present. Whether the organosilicon compound has the moiety of formula (1), (2) or (3) can be confirmed by gas chromatography/mass spectrometry (GC-MS).

The ratio of the organosilicon compound in the connection 11 is preferably 1% to 15.0%, more preferably 3% to 10%, by mass relative to the mass of copper of the connection 11. The ratio of the organosilicon compound can be determined by, for example, the following method. The mass loss (Y mass%) of a conductive composition containing X mass% of copper particles on firing by heating is determined using a thermogravimetric-differential thermal analyzer (TG-DTA). A calculation is made according to formula (A) below. The TG-DTA was operated in a nitrogen atmosphere at a rate of temperature rise of 10°C/min.

$$\text{Ratio of organosilicon compound in connection of connection structure (mass\%)} = (100 - X - Y) \times 100/(100 - Y) \qquad (A)$$

In connection with the ratio of the organosilicon compound in the connection 11, the fraction of the void volume in the total volume of the connection 11, i.e., the porosity of the connection 11 is preferably 1.0% to 30.0%, more preferably 5.0% to 20.0%. The porosity can be determined by magnifying observation of a cross-section of the connection 11 under an electron microscope and image analysis of an electron micrograph thereof. Although the porosity as calculated from an electron micrograph is an area ratio (%) of voids and is not technically a volumetric fraction of three-dimensional voids, the area ratio is regarded as a fraction of the void volume in the connection 11 for the sake of convenience. With the porosity being within the preferred range recited, the stress caused by dimensional changes of the connection 11 accompanying thermally induced expansion and contraction is alleviated, thereby to provide a connection structure with high bonding strength and low resistance.

It is preferred to adjust the thickness of the connection 11 so as to ensure the bond between the wiring board 20 and the electronic component 30 and sufficiently high electrical conductivity. For example, the thickness of the connection 11 is preferably 5 to 100 μm, more preferably 10 to 50 μm. The thickness of the connection 11 may be adjusted by, for example, adjusting the amount of a conductive composition to be applied in a preferred method for making the connection structure 10 described later. The thickness of the connection 11 is measured through electron microscopic observation of a polished cross-section of a resin-embedded connection 11.

The presence of the organosilicon compound in the voids of the connection 11 effectively prevents oxidation of copper and improves thermal dimensional stability of the connection 11. Nevertheless, excessive use of the organosilicon compound can be a cause of an increase in electrical resistance of the connection 11. Then, as stated earlier, it is particularly preferred that the connection 11 have a microstructure composed of a plurality of large-diameter copper particles that are relatively large in diameter and small-diameter copper particles that are smaller in diameter than the large-diameter copper particles, the large-diameter copper particles each being fusion bonded to small-diameter copper particles, the small-diameter copper particles being fusion bonded to each other, and a plurality of small-diameter copper particles being located around the large-diameter copper particle. When the connection 11 has such a microstructure, the amount of the organosilicon compound may be allowed to be reduced with a view to holding down an increase in electrical resistance, and yet, sufficiently high dimensional stability is achieved.

The copper making up the connection 11 preferably has a crystallite size of 45 to 150 nm, more preferably 55 to 100 nm, as measured by XRD. Advantageously, the copper particles having a crystallite size falling within the range recited are ready to be fusion bonded together to provide a firm connection structure. A connection 11 made up of copper whose crystallite size is in that range is obtained by, for example, using specific copper powder in the hereinafter described preferred method for making the connection structure 10.

A preferred method for making the connection structure 10 of the embodiment will be described with reference to Fig. 2. The connection structure 10 is advantageously fabricated by using a conductive composition described later. The conductive composition contains specific copper powder as will be described.

As illustrated in Fig. 2(a), a conductive composition 12 is applied to a conductive land 21 of a wiring board 20. The conductive composition 12 may be applied to the conductive land 21 by various techniques, including screen printing, dispenser printing, gravure printing, and offset printing. The amount of the conductive composition 12 to be applied is decided as appropriate to the designed thickness of the connection 11.

The terminal 31 of the electronic component 30 and the conductive land 21 of the wiring board 20 preferably have their surface made of copper or gold in view of the compatibility with copper powder of the conductive composition 12.

With the conductive composition 12 thus applied onto the conductive land 21 of the wiring board 20, the electronic component 30 is located with its terminal 31 facing the conductive land 21 of the wiring board 20, and the terminal 31 is then brought into contact with the conductive land 21 via the conductive composition 12 as illustrated in Fig. 2(b). While keeping this state, the resulting structure is heat-treated to fire the conductive composition 12, thereby to form a

desired connection structure 10 as illustrated in Fig. 2(c).

The firing is preferably carried out in an inert gas atmosphere. Nitrogen or argon may be used advantageously as an inert gas. The firing temperature is preferably 150° to 350°C, more preferably 230° to 300°C. The firing time is preferably 5 to 60 minutes, more preferably 7 to 30 minutes, provided that the firing temperature is in the range above.

The thus obtained connection structure 10 is suited for application to electronic circuits that may be exposed to a high temperature environment, such as on-board electronic circuits and electronic circuits having a power device mounted thereon, using its properties such as high heat resistance and high bonding strength.

The conductive composition that can suitably be used in the above mentioned method will then be described. The conductive composition contains the following components (a) to (d):

(a) large-diameter copper particles with a relatively large diameter;
(b) small-diameter copper particles smaller in diameter than the large-diameter copper particles;
(c) an amine compound; and
(d) a silane coupling agent having a group reactive with the amine compound.

These components will be described below.

The large-diameter copper particles as component (a) play a role like an aggregate in the conductive composition. The large-diameter copper particles are made mainly of copper. For example, the large-diameter copper particles may substantially solely comprise copper with the balance being unavoidable impurities or may comprise copper as a main ingredient (e.g., in a proportion exceeding 50% by mass) and other additional component(s). The large-diameter copper particles preferably comprise at least 90 mass% of copper from the viewpoint of conductivity. The large-diameter copper particles have a particle size of 1 to 10 μm, more preferably 1 to 6 μm, in terms of a volume cumulative particle diameter at 50% cumulative volume, $D_{50}$, in particle size distribution measurement by the laser diffraction/scattering method.

The $D_{50}$ can be determined by, for example, the following method. A sample to be analyzed weighing 0.1 g is mixed with 100 ml of a 20 mg/l aqueous solution of sodium hexametaphosphate and dispersed for 10 minutes using an ultrasonic homogenizer (US-300T available from Nihonseiki Kaisha Ltd.); and the resulting dispersion is then analyzed for particle size distribution using a laser diffraction/scattering particle size distribution analyzer, e.g., Microtrac X-100 from Nikkiso Co., Ltd.

The large-diameter copper particles may be spherical or otherwise shaped, such as flaky, platy, or rod-like. The shape of the large-diameter copper particles depends on the process of preparation. For example, copper particles obtained by a wet reduction process or an atomization process tend to take on a spherical shape, and those obtained by an electrochemical reduction process tend to assume a dendritic or rod-like shape. Flaky particles may be obtained by, for example, plastically flattening spherical particles by applying a mechanical outer force.

The content of the large-diameter copper particles in the conductive composition is preferably 4% to 70%, more preferably 20% to 50%, by mass.

The small-diameter copper particles as component (b) serve to fill the gaps between the large-diameter copper particles in the conductive composition. The small-diameter copper particles are made mainly of copper. For example, they may substantially solely comprise copper with the balance being unavoidable impurities or may comprise copper as a main component (e.g., in a proportion exceeding 50% by mass) and other additional component(s). The small-diameter copper particles have a particle size of 0.15 to 1.0 μm, more preferably 0.20 to 0.70 μm, in terms of a volume cumulative particle size at 50% cumulative volume, $D_{50}$, in particle size distribution measurement by the laser diffraction/scattering method.

As described above, the $D_{50}$ of the small-diameter copper particles is smaller than that of the large-diameter copper particles. More specifically, the $D_{50}$ of the small-diameter copper particles is preferably 1.5% to 80%, more preferably 2.5% to 70%, even more preferably 5% to 30%, of the $D_{50}$ of the large-diameter copper particles. When the large-diameter and small-diameter particles are related to each other in size as described, the gaps between the large-diameter copper particles are filled well with the small-diameter copper particles to successfully form voids with desired size and porosity.

The small-diameter copper particles may be spherical or otherwise shaped, such as flaky or platy. It is particularly preferred in terms of packing properties that the small-diameter copper particles be similarly shaped to the large-diameter copper particles to which they are combined.

The content of the small-diameter copper particles in the conductive composition is preferably 24 to 2080 parts, more preferably 74 to 340 parts, by mass per 100 parts by mass of the large-diameter copper particles.

The small-diameter copper particles preferably have an average primary particle diameter D of 0.15 to 0.6 μm, more preferably 0.15 to 0.4 μm. It has been unexpectedly ascertained that copper particles whose D is in that range are less liable to agglomerate without providing the particles with a surface protective layer and that the connection 11 formed of a conductive composition containing such small-diameter copper particles is so dense as to have high conductivity. The term "average primary particle diameter D of the small-diameter copper particles" as used herein refers to a volume average particle size of spheres calculated from Feret's diameters of a plurality of particles measured on an image of a scanning electron microscope.

It is preferred for the small-diameter copper particles to have no surface layer for protection from agglomeration (the layer will also be referred to as a protective layer). For the small-diameter copper particles to have an average primary particle diameter D in the above specified range and to have no protective layer on their surface make a great contribution to their low-temperature sinterability. A protective layer may be formed by post-treating a produced copper powder with a surface treating agent for the purpose of, for example, improving the dispersibility of the copper powder. Examples of such a surface treating agent include various organic compounds, including fatty acids such as stearic acid, lauric acid, and oleic acid, and coupling agents containing a semi-metal or a metal, e.g., silicon, titanium, or zirconium. Even when a surface treating agent is not used in the post-treatment after the production of copper power, a protective layer can be formed by addition of a dispersant to a reactant mixture containing a copper source in the manufacture of copper powder by a wet reduction process. Examples of such a dispersant include phosphates such as sodium pyrophosphate, and organic compounds such as gum arabic.

In order to ensure the above discussed improvement in low-temperature sinterability of the small-diameter copper particles, the small-diameter copper particles are preferably as free as possible from the elements that can form the protective layer. Specifically, the total content of carbon, phosphorus, silicon, titanium, and zirconium that have been present in conventional copper powders as protective layer-forming elements is preferably 0.10 mass% or less, more preferably 0.08 mass% or less, even more preferably 0.06 mass% or less, relative to the small-diameter copper particles.

Although a smaller total content of the above described elements leads to a better result, sufficient improvement on low-temperature sinterability of the small-diameter copper particles will be secured when the total content is not more than about 0.1 mass%. On an account of the carbon content of the small-diameter copper particles, sintering the conductive composition to form the connection 11 may be accompanied by evolution of carbon-containing gas, which can cause cracking in the resulting film or separation of the connection 11 from the conductive land 21 or terminal 31. Such an inconvenience will be prevented by reducing the carbon content of the small-diameter copper particles.

The small-diameter copper particles may be prepared by the same process as described for the large-diameter copper particles. It is preferred to use small-diameter copper particles prepared by the method described in WO 2014/080662.

The amine compound as component (c) is preferably represented by formula: $R_aR_bR_cN$, wherein $R_a$, $R_b$, and $R_c$ each represent a hydrogen atom or a hydrocarbon group optionally substituted with a functional group. $R_a$, $R_b$, and $R_c$ may be the same or different, provided that $R_a$, $R_b$, and $R_c$ do not represent hydrogen simultaneously.

The hydrocarbon group represented by $R_a$, $R_b$, or $R_c$ may be an alkyl group, an alkylene group, or an aromatic group, each preferably having 1 to 7 carbon atoms, more preferably 2 to 4 carbon atoms. Examples of the functional group that can replace a hydrogen atom of the hydrocarbon group include hydroxyl, aldehyde, and carboxyl.

Examples of suitable amine compounds include triethanolamine, diethanolamine, mono ethano lamine, dimethylaminoethanol, aminoethylethanolamine, n-butyldiethanolamine. These amine compounds may be used either individually or in combination of two or more thereof.

The content of the amine compound in the conductive composition is preferably 3 to 25 parts, more preferably 4 to 12 parts, by mass per 100 parts by mass of the sum of the large-diameter and the small-diameter copper particles. When the amine compound content is in that range, the amine compound reacts with a silane coupling agent, which will be described below, upon firing the conductive composition, to efficiently form an organosilicon compound in the connection 11. Excessive sintering of the copper particles during firing is thus controlled, that is, the conductive material 12 is prevented from excessive shrinkage, thereby to provide a connection 11 having voids and a desired dimension. Furthermore, the thus formed organosilicon compound lessens the stress caused by the dimensional changes associated with thermal expansion and contraction of the connection 11 and also minimizes oxidation of the connection 11 thereby to effectively prevent reduction of the connection 11 in mechanical strength.

The silane coupling agent as component (d) has a reactive group reactive with the amine compound (c). The silane coupling agent may be represented by formula: $R_d$-Si($OR_e$)$_3$. $R_d$ may be a group having a reactive moiety reactive with the amine compound, such as epoxy, amino, ureido, isocyanate, acryl, methacryl, or hydroxyl. $OR_e$ is a group reactive with the amine compound. $R_e$ represents a hydrogen atom or an alkyl group. The $R_e$'s may be the same or different.

Examples of suitable silane coupling agent include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane. These silane coupling agents may be used either individually or in combination of two or more thereof. The silane coupling agent may be used in combination with other coupling agents, such as aluminate coupling agents, titanate coupling agents, and zirconium coupling agents.

The content of the silane coupling agent in the conductive composition is preferably 1 to 12 parts, more preferably 3 to 10 parts, by mass per 100 parts by mass of the sum of the large-diameter and the small-diameter copper particles.

When the silane coupling agent content is in that range, the silane coupling agent efficiently forms an organosilicon compound in the connection 11 together with the amine compound upon firing the conductive composition. Excessive sintering of the copper particles during firing is thus controlled, that is, the conductive material 12 is prevented from excessive shrinkage, thereby to provide a connection 11 having voids and a desired dimension. Furthermore, the thus formed organosilicon compound alleviates the stress caused by the dimensional changes associated with thermal expansion and contraction of the connection 11 and also minimizes oxidation of the connection 11 thereby to effectively prevent reduction of the connection 11 in mechanical strength.

The conductive composition may contain, in addition to components (a) to (d) described above, other components, such as copper oxides, e.g., cuprous oxide ($Cu_2O$) and cupric oxide (CuO). The content of the copper oxide in the conductive composition is preferably 0.1 to 12 mass%, more preferably 0.1 to 5 mass%, relative to the sum of the large-diameter and the small-diameter copper particles. The copper oxides may be used either individually or in combination of two or more thereof. In the case where the conductive composition contains a copper oxide, it is advisable that firing of the conductive composition be carried out in a weakly reducing atmosphere. The weakly reducing atmosphere may be a hydrogen gas atmosphere diluted with an inert gas, such as nitrogen or argon. Specifically, a hydrogen/nitrogen atmosphere may be used. The hydrogen concentration of the hydrogen/nitrogen atmosphere is preferably 0.1 to 10 vol%, which range is at or below an explosion limit, more preferably 1 to 4 vol%.

The conductive composition may further contain other components, including various organic solvents. Examples of organic solvents include alcohols, such as methanol and ethanol, glycols, such as ethylene glycol and propylene glycol, and ketones, such as acetone and methyl ethyl ketone. The organic solvents may be used either individually or in combination of two or more thereof. The content of the organic solvent in the conductive composition is preferably 0.1 to 12 parts, more preferably 0.1 to 3 parts, by mass per 100 parts by mass of the sum of the large-diameter and the small-diameter copper particles.

The conductive composition can be obtained by mixing the above described components by a known mixing means, such as a roll mill or a mixer.

While the invention has been described with reference to its exemplary embodiments, it should be understood that the invention is not construed as being limited thereto. For instance, while in the preferred method for making the connection structure 10 illustrated in Fig. 2 the conductive composition 12 is applied to the conductive land 21 of the wiring board 20, the conductive composition 12 may be applied to the terminal 31 of the electronic component 30 or both the conductive land 21 and the terminal 31.

## Examples

The invention will now be illustrated in greater detail with reference to Examples, but the invention is not deemed to be limited thereto. Unless otherwise noted, all the percentages and parts are given by mass.

### Example 1

(1) Preparation of small-diameter copper particles

A round flask equipped with a stirring blade was provided. In the flask were put 15.71 g of copper acetate monohydrate as a copper source and then 50 g of water and 39.24 g of isopropyl alcohol as an organic solvent to prepare a reaction mixture. The reaction mixture was heated up to 60°C while stirring, and while continuing stirring, 27.58 g of hydrazine monohydrate was added thereto in three divided portions, followed by an additional one hour stirring at 60°C. after completion of the reaction, the whole reaction mixture was separated into solid and liquid. The solid was washed with pure water by decantation until the conductivity of the supernatant liquor decreased to 1000 $\mu$S/cm or less. The washed product was separated into solid and liquid. To the solid was added 160 g of ethanol, and the mixture was filtered using a press filter. The resulting solid was dried under reduced pressure at ambient temperature to give desired small-diameter copper particles. The resulting small-diameter copper particles were spherical, having an average primary particle diameter D of 240 nm and a $D_{50}$ of 0.44 $\mu$m.

(2) Providing of large-diameter copper particles

CS-20 (trade name), which was a copper powder obtained by a wet process available from Mitsui Mining & Smelting Co., Ltd., was used. The CS-20 particles were spherical with a $D_{50}$ of 3.0 $\mu$m.

(3) Preparation of conductive composition

Triethanolamine was used as an amine compound. 3-Glycidoxypropyltrimethoxysilane was used as a silane

coupling agent. Methanol was used as an organic solvent. A copper slurry was prepared by mixing 2.8 g of the small-diameter copper particles, 1.2 g of the large-diameter copper particles, and 0.3 g of the amine compound. Two gram of the copper slurry was mixed with 0.09 g of the silane coupling agent and 0.05 g of methanol to prepare a desired conductive composition.

(4) Making of connection structure

The conductive composition weighing 0.12 mg was applied to the center of a 5-mm square copper plate by dispenser printing. A 3-mm square copper plate was mounted thereon. The structure was fired in a nitrogen atmosphere at 300°C for 10 minutes to make a connection structure. The shear strength (MPa) of the resulting connection structure, being defined to be breaking load (N)/bond area ($mm^2$), was measured using a bond tester Condor Sigma from XYZTECH. The shear strength as measured was 47 MPa.

(5) Measurement of specific resistance of conductive film formed of conductive composition and thickness and porosity of connection of connection structure

The conductive composition was applied to a glass plate and fired at 300°C for 10 minutes to form a conductive film. The specific resistance of the conductive film was measured with a four-terminal resistance measuring device Loresta MCP-T600 from Mitsubishi Chemical Analytech Co., Ltd. and found to be 8 μΩ·cm.

A connection structure was made as described in (4) above, embedded in a resin, and polished. The polished cross-section of the connection structure was observed under an electron microscope to find the thickness of the connection to be 23 μm. The polished cross-section was prepared by fixing the connection structure in an embedding ring, pouring Epomount available from Refine Tec Ltd. (100 g of a base resin and 8 ml of a curing agent were mixed up beforehand) into the ring, followed by curing, and polishing the cured product with #800 to 2400 sandpaper until a cross-section of the connection structure was revealed.

The porosity of the connection was determined by image analysis. An electron micrograph was taken of the polished cross-section prepared above at magnifications of 10,000 times and analyzed using image analysis software Image-Pro Plus from Media Cybernetics, inc. The image was trinarized (artificially colored) into three phases -- metallic copper phase, organosilicon compound phase, and void phaseby making use of difference in contrast, and the area ratios of the three phases were calculated. As a result, the porosity was found to be 5.3%.

A cross-section of the connection structure was observed microscopically. The results are shown in Figs. 3(a) and 3(b). Fig. 3(a) is an electron micrograph at 10,000 magnifications, and Fig. 3(b) is an electron micrograph, at 50,000 magnifications, of the same field. As is clearly seen from Fig. 3(a), the connection has a microstructure in which a large-diameter copper particle is fused and bonded to a small-diameter copper particles, the small-diameter copper particles are fused and bonded to each other, and a plurality of small-diameter copper particles are located around the large-diameter copper particle. It is also seen that a void is formed between the large-diameter copper particle and the small-diameter particle and that a void is also formed between small-diameter particles. Fig. 3(b) shows that the connection has a microstructure composed of an aggregate of a plurality of particles that are fused and bonded to each other to form a neck therebetween. In addition, elemental mapping using EDX lent confirmation to the presence of an organosilicon compound in the voids as shown in Fig. 4.

(6) Ratio of organosilicon compound in connection of connection structure

The ratio of the organosilicon compound in the connection was calculated from the mass ratio of the copper particles in the conductive composition and the weight loss of the conductive composition when heated in a nitrogen atmosphere. Specifically, the mass loss of the conductive composition was measured using a thermogravimetric-differential thermal analyzer TG-DTA 2000SA available from Bruker AXS KK. The conductive composition containing 86.2% of copper particles was heated up to 300°C at a rate of 10°C/min and maintained at that temperature for 10 minutes, and the mass loss was found to be 6.3%. The ratio of the organosilicon compound in the connection of the connection structure was calculated from the mass loss according to formula (B) below and found to be 8.0 mass%.

Ratio of organosilicon compound in connection of connection structure = (100% - mass ratio of copper particles (86.2%) – mass loss on firing (6.3%)) x 100/(100% - mass loss on firing (6.3%))     (B)

(7) Crystallite size of copper in connection of connection structure

The conductive composition was printed on a glass plate and fired in nitrogen atmosphere at 300°C for 10 minutes to form a conductive film. The conductive film was analyzed by X-ray diffractometry using RINT-TTRIII from Rigaku Corp., and the crystallite size was calculated using the Cu (111) plane peak width by the Scherrer method. The crystallite size of the copper was found to be 84.9 nm.

Example 2

(1) Preparation of small-diameter copper particles

Small-diameter copper particles were prepared in the same manner as in (1) of Example 1.

(2) Providing of large-diameter copper particles

1400YM (trade name), which was a copper powder obtained by a wet process available from Mitsui Mining & Smelting Co., Ltd., was used. The 1400YM particles were spherical with a $D_{50}$ of 4.1 μm.

(3) Preparation of conductive composition

Triethanolamine was used as an amine compound. 3-Glycidoxypropyltrimethoxysilane was used as a silane coupling agent. Methanol was used as an organic solvent. A copper slurry was prepared by mixing 2.4 g of the small-diameter copper particles, 1.6 g of the large-diameter copper particles, and 0.3 g of the amine compound. Two gram of the copper slurry was mixed with 0.09 g of the silane coupling agent and 0.05 g of methanol to prepare a desired conductive composition.

(4) Making of connection structure

A connection structure was made in the same manner as in (4) of Example 1, except for changing the firing temperature to 270°C. The shear strength of the connection structure was determined by the same method as in Example 1 and found to be 35 MPa.

(5) Measurement of specific resistance of conductive film formed of conductive composition and thickness and porosity of connection of connection structure

The conductive composition was applied to a glass plate and fired to form a conductive film in the same manner as in (5) of Example 1, except for changing the firing temperature to 270°C. The specific resistance of the conductive film was measured in the same manner as in Example 1 and found to be 10 μΩ·cm.

A connection structure was made as described in (4) above. The connection structure was embedded in a resin and polished, and the polished cross-section was observed under an electron microscope in the same manner as in (5) of Example 1 to find the thickness of the connection to be 15 μm.

The porosity of the connection was determined by image analysis in the same manner as in (5) of Example 1 and found to be 18.6%.

(6) Ratio of organosilicon compound in connection of connection structure

The ratio of the organosilicon compound was calculated from the mass ratio of the copper particles in the conductive composition and the weight loss of the conductive composition when heated in a nitrogen atmosphere. Specifically, the mass loss of the conductive composition was measured using a thermogravimetric-differential thermal analyzer TG-DTA 2000SA available from Bruker AXS KK. The conductive composition containing 87.1% of copper particles was heated up to 270°C at a rate of 10°C/min and maintained at that temperature for 10 minutes, and the mass loss was found to be 6.6%. The ratio of the organosilicon compound in the connection of the connection structure was calculated from the mass loss according to formula (B) below and found to be 6.7 mass%.

Ratio of organosilicon compound in connection of connection structure = (100% - mass ratio of copper particles (87.1%) – mass loss on firing (6.6%)) x 100/(100% - mass loss on firing (6.6%)) (B)

(7) Crystallite size of copper in connection of connection structure

The conductive composition was printed on a glass plate and fired to form a conductive film in the same manner as in (7) of Example 1, except for changing the firing temperature to 270°C. The crystallite size of the copper of the conductive film was determined in the same manner as in Example 1 and found to be 64.5 nm.

Example 3

(1) Preparation of small-diameter copper particles

Small-diameter copper particles were prepared in the same manner as in (1) of Example 1.

(2) Preparation of conductive composition

Triethanolamine was used as an amine compound. 3-Glycidoxypropyltrimethoxysilane was used as a silane coupling agent. Methanol was used as an organic solvent. A copper slurry was prepared by mixing 4.0 g of the small-diameter copper particles and 0.4 g of the amine compound. Two gram of the copper slurry was mixed with 0.08 g of the silane coupling agent and 0.05 g of methanol to prepare a desired conductive composition.

(3) Making of connection structure

A connection structure was made in the same manner as in (4) of Example 1. The shear strength of the connection structure was determined by the same method as in Example 1 and found to be 34 MPa.

(4) Measurement of specific resistance of conductive film formed of conductive composition and thickness and porosity of connection of connection structure

The conductive composition was applied to a glass plate and fired to form a conductive film in the same manner as in (5) of Example 1. The specific resistance of the conductive film was measured in the same manner as in Example 1 and found to be 14 μΩ·cm.

A connection structure was made as described in (3) above. The connection structure was embedded in a resin and polished, and the polished cross-section was observed under an electron microscope in the same manner as in (5) of Example 1 to find the thickness of the connection to be 16 μm.

The porosity of the connection was determined by image analysis in the same manner as in (5) of Example 1 and found to be 5.5%.

(5) Ratio of organosilicon compound in connection of connection structure

The ratio of the organosilicon compound was calculated from the mass ratio of the copper particles in the conductive composition and the weight loss of the conductive composition when heated in a nitrogen atmosphere. Specifically, the mass loss of the conductive composition was measured using a thermogravimetric-differential thermal analyzer TG-DTA 2000SA available from Bruker AXS KK. The conductive composition containing 85.4% of copper particles was heated up to 300°C at a rate of 10°C/min and maintained at that temperature for 10 minutes, and the mass loss was found to be 10.6%. The ratio of the organosilicon compound in the connection of the connection structure was calculated from the mass loss according to formula (B) below and found to be 4.5 mass%.

Ratio of organosilicon compound in connection of connection structure = (100% - mass ratio of copper particles (85.4%) – mass loss on firing (10.6%)) x 100/(100% - mass loss on firing (10.6%)) (B)

(6) Crystallite size of copper in connection of connection structure

The conductive composition was printed on a glass plate and fired to form a conductive film in the same manner as in (7) of Example 1. The crystallite size of the copper of the conductive film was determined in the same manner as in Example 1 and found to be 57.2 nm.

Example 4

(1) Preparation of small-diameter copper particles

Small-diameter copper particles were prepared in the same manner as in (1) of Example 1.

(2) Providing of large-diameter copper particles

The same large-diameter copper particles as used in (2) of Example 1 were provided.

(3) Providing of cuprous oxide

High purity, reagent-grade cuprous oxide powder available from Kanto Chemical Co., Inc. (purity: 99.9 wt% or higher) was used.

(4) Preparation of conductive composition

Triethanolamine was used as an amine compound. 3-Glycidoxypropyltrimethoxysilane was used as a silane coupling agent. Methanol was used as an organic solvent. A copper slurry was prepared by mixing 2.17 g of the small-diameter copper particles, 1.71 g of the large-diameter copper particles, 0.12 g of the cuprous oxide powder, and 0.4 g of the amine compound. Two gram of the copper slurry was mixed with 0.08 g of the silane coupling agent and 0.05 g of methanol to prepare a desired conductive composition.

(5) Measurement of specific resistance of conductive film formed of conductive composition

The conductive composition was applied to a glass plate and fired in a 3 vol% hydrogen-nitrogen atmosphere at 350°C for 80 minutes to form a conductive film. The specific resistance of the conductive film was measured in the same manner as in Example 1 and found to be 14 $\mu\Omega\cdot$cm.

Example 5

(1) Preparation of small-diameter copper particles

Small-diameter copper particles were prepared in the same manner as in (1) of Example 1.

(2) Providing of large-diameter copper particles

The same large-diameter copper particles as used in (2) of Example 1 were provided.

(3) Providing of cupric oxide

Cupric oxide powder available from Kanto Chemical Co., Inc. (High purity, reagent-grade; purity: 99.9 wt% or higher) was used.

(4) Preparation of conductive composition

Triethanolamine was used as an amine compound. 3-Glycidoxypropyltrimethoxysilane was used as a silane coupling agent. Methanol was used as an organic solvent. A copper slurry was prepared by mixing 2.17 g of the small-diameter copper particles, 1.71 g of the large-diameter copper particles, 0.12 g of the cupric oxide powder, and 0.4 g of the amine compound. Two gram of the copper slurry was mixed with 0.08 g of the silane coupling agent and 0.05 g of methanol to prepare a desired conductive composition.

(5) Measurement of specific resistance of conductive film formed of conductive composition

The conductive composition was applied to a glass plate and fired in a 3 vol% hydrogen-nitrogen atmosphere at 350°C for 80 minutes to form a conductive film. The specific resistance of the conductive film was measured in the same manner as in Example 1 and found to be 17 μΩ·cm.

Comparative Example 1

(1) Preparation of small-diameter copper particles

Small-diameter copper particles were prepared in the same manner as in (1) of Example 1.

(2) Providing of large-diameter copper particles

The same large-diameter copper particles as used in (2) of Example 1 were provided.

(3) Preparation of conductive composition

Triethanolamine was used as an amine compound. Methanol was used as an organic solvent. A copper slurry was prepared by mixing 2.8 g of the small-diameter copper particles, 1.2 g of the large-diameter copper particles, and 0.3 g of the amine compound. Two gram of the copper slurry was mixed with 0.05 g of methanol to prepare an intended conductive composition.

(4) Making of connection structure

A connection structure was made in the same manner as in (4) of Example 1. The shear strength of the resulting connection structure was 1.4 MPa as measured in the same manner as in Example 1.

(5) Measurement of specific resistance of conductive film formed of conductive composition and thickness and porosity of connection of connection structure

The conductive composition was applied to a glass plate and fired at 300°C for 10 minutes to form a conductive film. The specific resistance and porosity of the resulting conductive film were unmeasurable because of lack of mechanical strength as conductive film on account of too many cracks and voids.

Industrial Applicability

The invention provides a conductor connection structure made mainly of copper, having voids, and containing a nitrogen-containing organosilicon compound. The presence of the organosilicon compound in an optimized ratio achieves alleviation of the stress caused by dimensional changes of the connection structure accompanying thermal expansion/contraction. The nitrogen-containing organosilicon compound prevents oxidation of the connection structure made mainly of copper. Thus, the connection structure of the invention exhibits high heat resistance, high bonding strength, and low resistance.

## Claims

1. A connection structure comprising two conductors and a copper connection electrically connecting the conductors, the connection being made mainly of copper, having a plurality of voids, and containing an organosilicon compound in the voids,
wherein the organosilicon compound has a moiety represented by formula (2):

[Chem. 1]

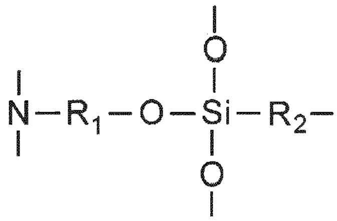

(2)

wherein $R_1$ and $R_2$ each represent a divalent hydrocarbon linking group.

**2.** The connection structure according to claim 1, wherein the connection has a microstructure comprising an aggregate of a plurality of particles that are fused and bonded to each other to form a neck therebetween.

**3.** The connection structure according to claim 1 or 2, wherein the connection has a microstructure comprising a plurality of large-diameter copper particles and small-diameter copper particles having a smaller diameter than the large-diameter copper particles, the large-diameter copper particles each being fused and bonded to the small-diameter copper particles, the small-diameter copper particles being fused and bonded to each other, and a plurality of the small-diameter copper particles being located around the large-diameter copper particle, and
the voids include a first void and a second void, the first void being formed between the large-diameter copper particle and the small-diameter copper particle which are fusion-bonded to each other and the second void being formed between the small-diameter copper particles which are fusion-bonded to one another.

**4.** An electroconductive composition that can be used for making the connection structure according to any one of claims 1 to 3 comprising large-diameter copper particles, small-diameter copper particles having a smaller diameter than the large-diameter copper particles, an amine compound, and a silane coupling agent having a reactive group reactive with the amine compound,
the large-diameter copper particles having a particle size of 1 to 10 μm in terms of a volume cumulative particle diameter at 50% cumulative volume, $D_{50}$, in particle size distribution measurement by the laser diffraction/scattering method, and
the small-diameter copper particles having a particle size of 0.15 to 1.0 μm in terms of a volume cumulative particle diameter at 50% cumulative volume, $D_{50}$, in particle size distribution measurement by the laser diffraction/scattering method.

**5.** A method for making the connection structure according to any one of claims 1 to 3 with the electroconductive composition according to claim 4, comprising:

allowing the electroconductive composition to intervene between two conductors, and
heat-treating the electroconductive composition between the conductors to form a conductive connection, thereby achieving electrical connection between the conductors.

**6.** An electronic component module comprising a wiring board having a conductive land, an electronic component mounted on the conductive land and having a terminal, and a copper connection electrically connecting the conductive land and the terminal,
the connection being made mainly of copper, having a plurality of voids, and containing an organosilicon compound in the voids,
wherein the organosilicon compound has a moiety represented by formula (2):

[Chem. 1]

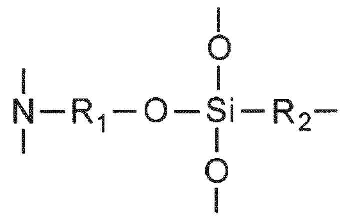

(2)

wherein $R_1$ and $R_2$ each represent a divalent hydrocarbon linking group.

**Patentansprüche**

1. Verbindungsstruktur, die zwei Leiter und eine Kupferverbindung umfasst, die die Leiter elektrisch verbindet, wobei die Verbindung hauptsächlich aus Kupfer hergestellt ist, mehrere Hohlräume aufweist und eine Organosiliciumverbindung in den Hohlräumen enthält,
wobei die Organosiliciumverbindung eine Einheit aufweist, die durch Formel (2) dargestellt wird:

[Chem. 1]

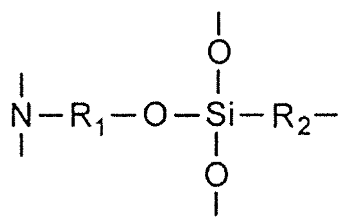

(2)

worin $R_1$ und $R_2$ jeweils eine zweiwertige Kohlenwasserstoffverbindungsgruppe darstellen.

2. Verbindungsstruktur nach Anspruch 1, wobei die Verbindung eine Mikrostruktur aufweist, die ein Aggregat aus mehreren Partikeln umfasst, die miteinander verschmolzen und verbunden sind, um einen Hals dazwischen zu bilden.

3. Verbindungsstruktur nach Anspruch 1 oder 2, wobei die Verbindung eine Mikrostruktur aufweist, die mehrere Kupferpartikel mit großem Durchmesser und mehrere Kupferpartikel mit kleinem Durchmesser mit einem kleineren Durchmesser als die Kupferpartikel mit großem Durchmesser umfasst, wobei die Kupferpartikel mit großem Durchmesser jeweils mit den Kupferpartikeln mit kleinem Durchmesser verschmolzen und verbunden sind, wobei die Kupferpartikel mit kleinem Durchmesser miteinander verschmolzen und verbunden sind und mehrere der Kupferpartikel mit kleinem Durchmesser um Kupferpartikel mit großem Durchmesser angeordnet sind, und die Hohlräume einen ersten Hohlraum und einen zweiten Hohlraum umfassen, wobei der erste Hohlraum zwischen einem Kupferpartikel mit großem Durchmesser und einem Kupferpartikel mit kleinem Durchmesser gebildet wird, die miteinander verschmolzen sind, und der zweite Hohlraum zwischen den Kupferpartikeln mit kleinem Durchmesser gebildet werden, die miteinander verschmolzen sind.

4. Elektrisch leitende Zusammensetzung, die zur Herstellung der Verbindungsstruktur nach einem der Ansprüche 1 bis 3 verwendet werden kann, umfassend Kupferpartikel mit großem Durchmesser, Kupferpartikel mit kleinem Durchmesser mit einem kleineren Durchmesser als die Kupferpartikel mit großem Durchmesser, eine Aminverbindung und ein Silankupplungsmittel mit einer reaktiven Gruppe, die mit der Aminverbindung reagieren kann,
wobei die Kupferpartikel mit großem Durchmesser eine Partikelgröße von 1 bis 10 $\mu$m, ausgedrückt als kumulativer Volumen- Teilchendurchmesser bei 50% kumulativem Volumen, $D_{50}$, bei der Messung der Partikelgrößenverteilung durch das Laserbeugungs-/Streuungsverfahren aufweisen und
die Kupferpartikel mit kleinem Durchmesser mit einer Partikelgröße von 0,15 bis 1,0 $\mu$m, ausgedrückt als kumulativer

Volumen-Teilchendurchmesser bei 50% kumulativem Volumen, $D_{50}$, bei der Messung der Teilchengrößenverteilung durch das Laserbeugungs-/Streuungsverfahren aufweisen.

**5.** Verfahren zur Herstellung der Verbindungsstruktur nach einem der Ansprüche 1 bis 3 mit der elektrisch leitenden Zusammensetzung nach Anspruch 4, umfassend:

Ermöglichen, dass die elektrisch leitende Zusammensetzung zwischen zwei Leitern angeordnet wird, und Wärmebehandlung der elektrisch leitenden Zusammensetzung zwischen den Leitern, um eine leitende Verbindung zu bilden,
wodurch eine elektrische Verbindung zwischen den Leitern erreicht wird.

**6.** Elektronisches Komponentenmodul, umfassend eine Verdrahtungsplatine mit einem leitenden Steg, eine elektronische Komponente, die auf dem leitenden Steg montiert ist und einen Anschluss aufweist, und eine Kupferverbindung, die den leitenden Steg und den Anschluss elektrisch verbindet; wobei die Verbindung hauptsächlich aus Kupfer hergestellt wird, mehrere Hohlräume aufweist und eine Organosiliciumverbindung in den Hohlräumen enthält, wobei die Organosiliciumverbindung eine Einheit aufweist, die durch die Formel (2) dargestellt wird:

[Chem. 1]

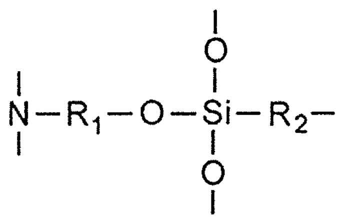

(2)

worin $R_1$ und $R_2$ jeweils eine zweiwertige Kohlenwasserstoffverbindungsgruppe darstellen.

## Revendications

**1.** Structure de connexion comprenant deux conducteurs et une connexion en cuivre reliant électriquement les conducteurs, la connexion étant constituée principalement de cuivre, présentant une pluralité de vides, et contenant un composé organosilicié dans les vides,
dans lequel le composé organosilicié a un groupement représenté par la formule (2):

[Chem. 1]

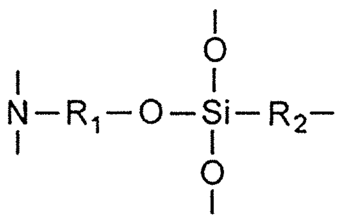

(2)

où $R_1$ et $R_2$ représentent chacun un groupe de liaison hydrocarboné divalent.

**2.** Structure de connexion selon la revendication 1, dans laquelle la connexion a une microstructure comprenant un agrégat d'une pluralité de particules qui sont fusionnées et liées les unes aux autres pour former un col entre elles.

**3.** Structure de connexion selon la revendication 1 ou 2, dans laquelle la connexion a une microstructure comprenant une pluralité de particules de cuivre de grand diamètre et de particules de cuivre de petit diamètre ayant un diamètre

plus petit que les particules de cuivre de grand diamètre, les particules de cuivre de grand diamètre, chacune étant fusionnée et liée aux particules de cuivre de petit diamètre, les particules de cuivre de petit diamètre étant fusionnées et liées les unes aux autres, et une pluralité de particules de cuivre de petit diamètre étant situées autour de la particule de cuivre de grand diamètre, et
les vides comprennent un premier vide et un deuxième vide, le premier vide étant formé entre la particule de cuivre de grand diamètre et la particule de cuivre de petit diamètre qui sont liées par fusion l'une à l'autre et le deuxième vide étant formé entre les particules de cuivre de petit diamètre liées par fusion les unes aux autres.

**4.** Composition électroconductrice utilisable pour réaliser la structure de connexion selon l'une quelconque des revendications 1 à 3 comprenant des particules de cuivre de grand diamètre, des particules de cuivre de petit diamètre ayant un diamètre plus petit que les particules de cuivre de grand diamètre, un composé amine, et un agent de couplage silane ayant un groupe réactif réactif avec le composé amine, les particules de cuivre de grand diamètre ayant une taille de particule de 1 à 10 $\mu$m en termes d'un diamètre de particule cumulé en volume à 50% du volume cumulé, $D_{50}$, dans la mesure de la distribution granulométrique par le procédé de diffraction/diffusion laser, et
les particules de cuivre de petit diamètre ayant une taille de particule de 0,15 à 1,0 $\mu$m en termes d'un diamètre de particule cumulé en volume à 50% du volume cumulé, Dso, dans la mesure de la distribution granulométrique par le procédé de diffraction/diffusion laser.

**5.** Procédé de réalisation de la structure de connexion selon l'une quelconque des revendications 1 à 3 avec la composition électroconductrice selon la revendication 4, comprenant:

permettre à la composition électroconductrice d'être placeée entre deux conducteurs, et
traiter thermiquement la composition électroconductrice entre les conducteurs pour former une connexion conductrice,
réalisant ainsi une connexion électrique entre les conducteurs.

**6.** Module de composant électronique comprenant une carte de câblage comportant une plage conductrice, un composant électronique monté sur la plage conductrice et ayant une borne, et une connexion en cuivre reliant électriquement la plage conductrice et la borne,
la connexion étant constituée principalement de cuivre, comportant une pluralité de vides, et contenant un composé organosilicié dans les vides,
dans lequel le composé organosilicié a un groupement représenté par la formule (2):

[Chem. 1]

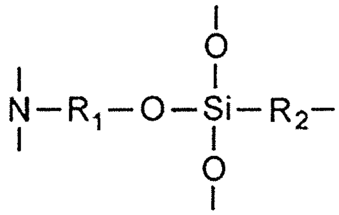

(2)

où $R_1$ et $R_2$ représentent chacun un groupe de liaison hydrocarboné divalent.

Fig. 1

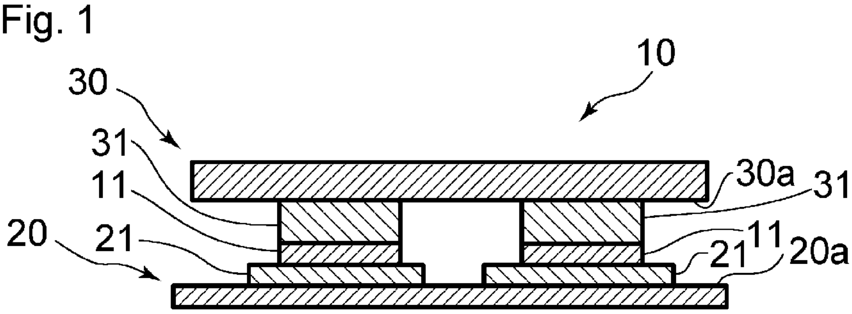


Fig. 2(a)

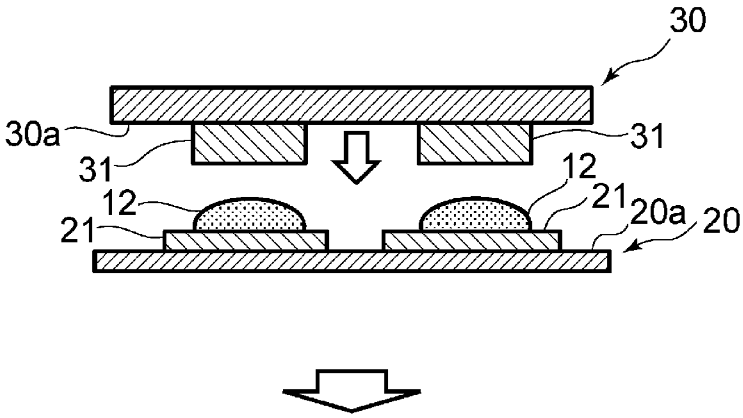


Fig. 2(b)

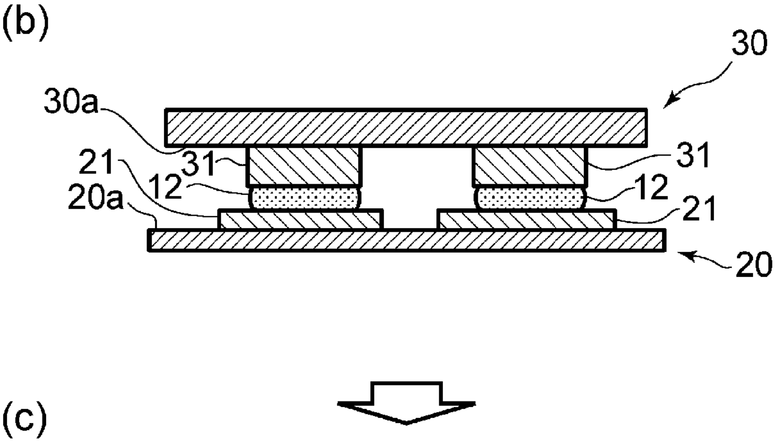


Fig. 2(c)

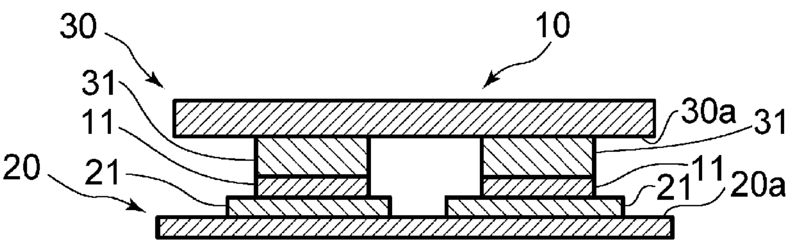

Fig. 3(a)

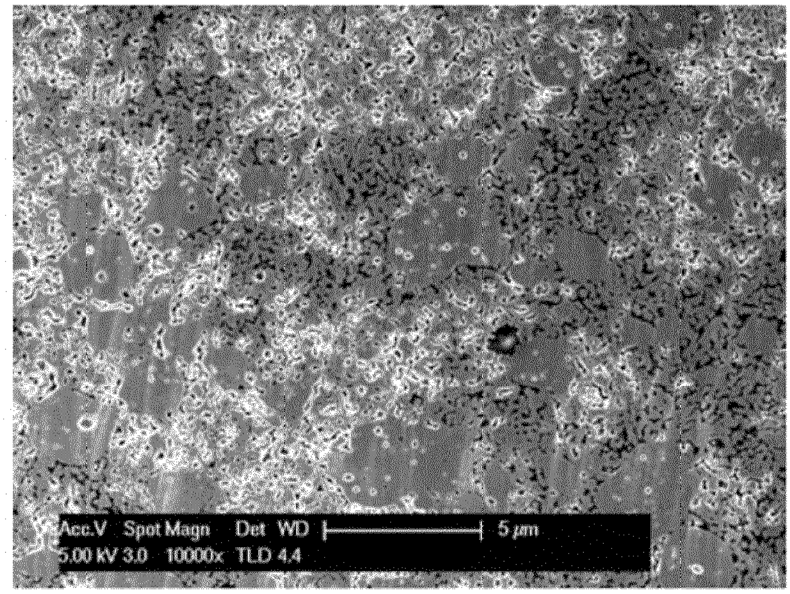
Acc.V Spot Magn Det WD 5 µm
5.00 kV 3.0 10000x TLD 4.4

Fig. 3(b)

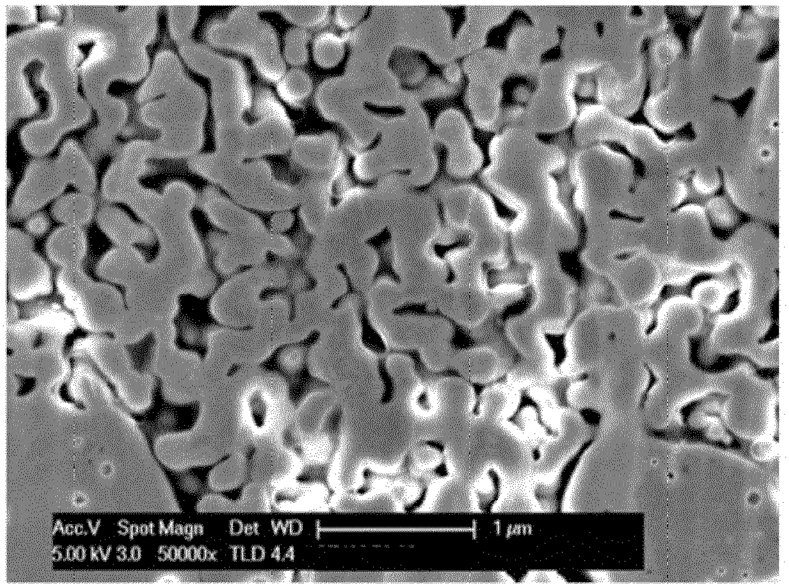
Acc.V Spot Magn Det WD 1 µm
5.00 kV 3.0 50000x TLD 4.4

Fig. 4

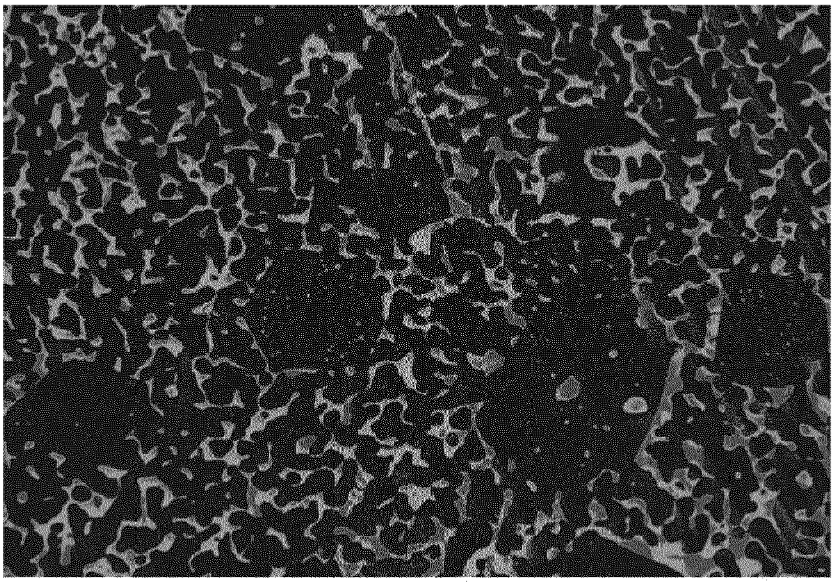

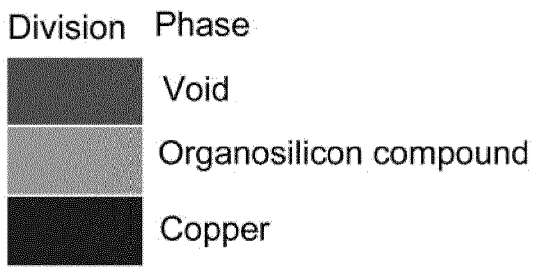

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011238737 A
- JP 2010065277 A
- JP H10312712 A
- WO 2014080662 A